# FASCICULE DE BREVET EUROPEEN

(11) **EP 1 636 130 B1**
(45) Date de publication et mention de la délivrance du brevet: **25.05.2016**
(21) Numéro de dépôt: 04767421.3
(22) Date de dépôt: 23.06.2004
(51) Int. Cl.: B81B 7/00, H01L 21/822, H01L 21/02, H01L 21/334, H01L 23/00, H01L 29/94

(54) **CIRCUIT INTEGRE SUR PUCE DE HAUTES PERFORMANCES**
INTEGRIERTE SCHALTUNG AUF HOCHLEISTUNGSCHIP
INTEGRATED CIRCUIT ON HIGH PERFORMANCE CHIP

(30) Priorité: 24.06.2003 FR 0307617
(43) Date de publication de la demande: 22.03.2006
(73) Titulaire: Commissariat à l'Énergie Atomique et aux Énergies Alternatives, 75015 Paris (FR)
(72) Inventeur: JOLY, Jean-Pierre, F-38120 Saint-Egrève (FR); ULMER, Laurent, F-38100 Grenoble (FR); PARAT, Guy, F-38640 Claix (FR)
(74) Mandataire: Santarelli
(86) Numéro de dépôt international: PCT/FR2004/001565
(87) Numéro de publication internationale: WO 2005/000733

(56) Documents cités:
- EP-A- 1 096 259
- WO-A-03/021667
- DE-A- 10 153 319
- US-A1- 2001 038 148
- US-A1- 2002 000 646
- US-A1- 2002 185 469
- US-A1- 2003 001 221
- US-B1- 6 306 720
- US-B1- 6 407 929

## Description

La présente invention concerne le domaine des circuits intégrés, et notamment celui des composants passifs intégrés sur puce.

Dans le domaine des circuits intégrés, on cherche de plus en plus :
- à réduire la taille prise par les composants,
- à diminuer les coûts de fabrication, et
- à introduire de nouvelles fonctions.

Pour atteindre ces objectifs, il est nécessaire d'intégrer de façon collective sur une même puce de circuit intégré analogique ou numérique, un nombre de plus en plus grand de composants qui étaient autrefois fabriqués séparément. Il s'agit essentiellement de trois catégories de composants : d'une part les circuits dits « actifs » (transistors), d'autre part les composants dits « passifs » (résistances, condensateurs, inductances), et enfin les MEMS (initiales des mots anglais « *Micro-Electro-Mechanical Systems* », c'est-à-dire « Systèmes Electro-mécaniques Microscopiques ») (filtres acoustiques, interrupteurs radiofréquence, condensateurs à capacités variables).

On peut intégrer les composants passifs et/ou les MEMS indépendamment des transistors, mais leur intégration monolithique avec les transistors est la plus intéressante en terme de compacité et de coût. Toutefois, cette intégration monolithique se heurte à un certain nombre de difficultés technologiques.

Premièrement, la nature des couches, ou les traitements nécessités par la fabrication des composants passifs, ne sont pas toujours facilement compatibles avec une fabrication sur les circuits actifs.

Par exemple, il existe des cas où l'élaboration d'un second matériau après celle d'un premier matériau dans un empilement sur tranche de silicium nécessite l'utilisation d'une température supérieure à celle à partir de laquelle ledit premier matériau subit des dégradations inacceptables. C'est notamment le cas pour l'intégration de condensateurs de découplage dans les circuits intégrés. Ces condensateurs doivent stocker une charge électrique élevée ; la charge électrique étant proportionnelle à la capacité et à la tension d'alimentation, l'augmentation de la capacité permet l'amélioration des performances recherchées (on rappelle que la capacité est proportionnelle à la constante diélectrique, à la surface d'électrode, et à l'inverse de l'épaisseur du diélectrique du condensateur).

On réalise classiquement les condensateurs sur la même tranche que les transistors. Pour abaisser les coûts de production, il est naturellement souhaitable d'utiliser à cet effet des condensateurs de petite taille. On peut alors envisager d'obtenir les capacités requises en faisant appel à des matériaux diélectriques à très haute constante diélectrique comparativement aux matériaux usuels (SiO₂, Si₃N₄, Ta₂O₅, ZrO₂, ou Al₂O₃).

Or il existe des matériaux ferroélectriques, appartenant à la classe des « pérovskites », qui possèdent des constantes diélectriques très élevées (constante relative de plusieurs centaines d'unités) ; les pérovskites constituent l'essentiel des matériaux étudiés pour des applications de condensateurs à forte capacité dans la gamme souhaitée de constantes diélectriques (voir par exemple l'article de T. Ayguavives et al. intitulé « Physical Properties of (Ba,Sr)TiO3 Thin Films used for Integrated Capacitors in Microwave Applications », IEEE 2001). La phase cristalline pérovskite s'obtient à des températures habituellement comprises entre 600°C et 700°C. Mais de telles températures sont incompatibles avec le métal d'interconnexion des transistors, à base d'aluminium ou de cuivre. Si certains procédés connus à basse température (voir par exemple l'article de D. Liu et al. intitulé « Integrated Thin Film Capacitor Arrays », International Conférence on High Density Packaging and MCMs, 1999) font appel à une pérovskite, ils concernent en fait une phase où la pérovskite n'est pas pure ou est de qualité structurale ou micro-structurale médiocre, ce qui fait que la constante diélectrique est très inférieure à celle du même matériau recuit à plus haute température.

Les procédés classiques mentionnés ci-dessus ne permettent donc pas de tirer véritablement parti des avantages des pérovskites. En effet, la température maximum autorisée décroît progressivement au fur et à mesure des étapes réalisées, et la principale difficulté provient de ce que la mise en place d'un matériau à procédé « chaud » (le diélectrique) intervient chronologiquement après celle d'un matériau à procédé « froid » (le métal d'interconnexion).

On connaît néanmoins une méthode pour porter le diélectrique à plus haute température que ce que peuvent supporter les métaux d'interconnexion. Cette méthode consiste à isoler le diélectrique du métal d'interconnexion par une couche de protection thermique, puis à recuire le diélectrique à l'aide d'un laser à impulsions suffisamment brèves pour que, si la diffusion thermique est assez faible, la température du métal demeure inférieure à la température du diélectrique et soit acceptable (voir par exemple l'article de P.P. Donohue et al. intitulé « Pulse-Extended Excimer Laser Annealing of Lead Zirconate Titanate Thin Films », Actes du 12ème Symposium International sur les Ferroélectriques Intégrés, Aachen, Allemagne, mars 2000, publié dans Integrated Ferroelectrics, vol. 31, pages 285 à 296, 2000). Le contrôle de cette méthode est toutefois délicat, car la couche de protection reste à terme sur la tranche. Elle ne peut donc pas être très épaisse (elle est habituellement inférieure à 2 µm), et elle peut affecter les performances électriques des dispositifs. La différence de température entre le métal d'interconnexion et le diélectrique est donc limitée, autrement dit la température à laquelle le diélectrique peut être soumise est limitée. De plus, l'empilement est soumis à un fort gradient thermique pendant cette opération, ce qui peut engendrer une température de surface trop élevée, une cristallisation non homogène du diélectrique, ou encore des dégradations de matériaux, comme des microfissures, dues aux dilatations thermiques.

Une solution connue à ce problème de température consiste à réaliser les dispositifs passifs intégrant les condensateurs sur une autre tranche de silicium que le substrat contenant les composants actifs, puis à connecter les deux puces entre elles par câblage filaire ou par l'intermédiaire de microbilles (voir par exemple l'article de R. Heistand et al. intitulé « Advances in Passive Integration for C/RC Arrays & Networks with Novel Thin & Thick Film Materials », 36ème Conférence Nordique IMAPS, Helsinki, 1999). Mais ces méthodes présentent certains inconvénients :
- le câblage filaire ne permet pas d'établir des connexions de courte distance entre condensateurs et transistors, et
- les connexions par microbilles ne peuvent être réalisées qu'une fois au-dessus d'un circuit ; si les condensateurs sont réalisés de cette manière, il n'est plus possible de rajouter d'autres fonctions telles que, par exemple, des micro-interrupteurs ou des filtres à onde de surface.

Pour éviter ces problèmes, on limite classiquement la température d'élaboration à 450°C environ, ce qui permet d'intégrer les composants dans les métallisations usuelles, ou au-dessus d'elles, dans les circuits intégrés à base d'aluminium ou de cuivre (voir par exemple l'article de S. Jenei et al. intitulé « High-Q Inductors and Capacitors on Si Substrate », IEEE 2001, ou l'article de Bryan C. Hendrix et al. intitulé « Low-Temperature Process for High-Density Thin-Film lntegrated Capacitors », International Conférence on High-Density Interconnect and Systems Packaging, 2000). De ce fait, ces procédés classiques sont fortement limités en ce qui concerne le type de matériau et les constantes diélectriques accessibles. Les capacités désirées sont donc atteintes en ayant recours à des condensateurs de grande surface, ce qui limite les possibilités d'intégration, et entraîne un surcoût de la puce en raison de l'augmentation de la surface qu'elle occupe sur la tranche de silicium.

On connaît néanmoins une méthode pour augmenter la surface des électrodes sans pour autant augmenter les dimensions latérales de la puce (voir l'article de F. Roozeboom et al. intitulé « High-Value MOS Capacitor Arrays in Ultradeep Trenches in Silicon », publié dans Microelectronic Engineering, vol. 53, pages 581 à 584, Elsevier Science 2000). Cette méthode consiste à exploiter la profondeur du substrat pour intégrer des condensateurs de découplage de type MOS (initiales des mots anglais « *Metal-Oxide-Semiconductor*»), en creusant un réseau de tranchées étroites et profondes dans le substrat : on dispose autour de ces tranchées d'abord une couche de diélectrique, puis une couche formant électrode ; l'autre électrode du réseau de condensateurs recouvre la surface du substrat. Mais outre la difficulté de réaliser des couches de diélectrique uniformes dans les tranchées, l'utilisation de condensateurs en tranchées rend difficile l'intégration planaire des composants passifs avec les composants actifs.

Plus généralement, on voit qu'une deuxième difficulté soulevée par l'intégration monolithique des composants passifs ou des MEMS avec les transistors est qu'on ne peut profiter de la dimension verticale pour obtenir de meilleures caractéristiques, ou une meilleure compacité pour les composants passifs.

Une troisième difficulté soulevée par l'intégration monolithique des composants passifs ou des MEMS avec les transistors est que les caractéristiques des composants passifs sont perturbées par le type de substrat utilisé pour les circuits actifs.

A titre d'exemple, les substrats utilisés pour les circuits CMOS ou BICMOS ont des conductivités au plus de l'ordre de 10 Ω·cm. Les courants induits dans ces substrats par les inductances ou les lignes conductrices produisent des pertes importantes et diminuent ainsi les facteurs de qualité (grande inductance, fréquence de résonance élevée, faible capacité parasite) de ces structures.

Une première solution connue consiste à éliminer une partie du substrat sous les zones devant accueillir les inductances et les lignes conductrices (voir par exemple le brevet US-5,539,241). Une deuxième solution connue consiste à rendre isolant le substrat sous les zones devant accueillir les inductances et les lignes conductrices (voir par exemple l'article de H.-S. Kim et al. intitulé « A Porous-Si-based Novel Isolation Technology for Mixed-Signal Integrated Circuits », Symposium on VLSI Technology, 2000). On connaît encore une troisième solution, d'après le brevet US-6,310,387 : on structure les couches conductrices sous-jacentes en réalisant un grand nombre de petites zones conductrices en damier séparées les unes des autres par un isolant, et non reliées à la masse ; ces zones servent de blindage car il s'y forme, en fonctionnement, de petits courants de Foucault empêchant le champ magnétique de pénétrer jusqu'au substrat ; ces zones ont une taille suffisamment faible pour éviter que ces courants de Foucault n'induisent dans les inductances un flux magnétique opposé à celui qu'on veut créer.

Mais ces diverses techniques sont complexes à mettre en oeuvre, peuvent nuire à la robustesse du circuit intégré, et rendent difficile la mise en place des composants actifs.

Enfin, une difficulté soulevée spécifiquement par l'intégration monolithique des MEMS avec les transistors est qu'il faut ajouter un capot destiné à protéger les éléments mécaniques, sans perturber le fonctionnement de ces derniers. Une solution connue consiste à sceller une plaquette de silicium de même diamètre que la plaquette sur laquelle ont été réalisés les circuits (voir par exemple l'article de H. Tilmans et al. intitulé « Zero-Level Packaging for MEMS or MST Devices: the IRS Method »*,* mst*news* 1/00). Cette technologie est assez coûteuse: en effet, il faut ajouter au coût du substrat supplémentaire le coût du scellement, celui d'un amincissement, et celui d'une gravure locale pour accéder aux plots électriques de sortie à la surface du circuit, tout cela uniquement pour réaliser la fonction de protection par capotage.

D'une façon générale, on connaît, du document WO 03/021667, un procédé pour relier deux substrats, un premier substrat comportant des piliers pour conduire un signal électrique. Les deux substrats sont assemblés au niveau de ces piliers au moyen de billes de soudure, ces billes réalisant une interconnexion électrique entre substrats.

On connaît également, du document EP1096259, un micro-gyroscope réalisé en montant un premier substrat doté d'un circuit ASIC sur un deuxième substrat doté d'une structure suspendue de micro-gyroscope. Les deux substrats sont mis en contact physique et électrique par l'intermédiaire de plots métalliques soudés (co-melting bond).

On connaît également, du document DE10153319, un micro-capteur comportant un capteur monté sur un circuit intégré formé par un substrat et un circuit. Le capteur est scellé au substrat du circuit intégré par une liaison eutectique à une distance adaptée de sorte à permettre la connexion électrique directe entre ce capteur et le circuit porté par le substrat.

On connaît aussi, du document US 2002/000646, un procédé de fabrication de dispositifs MEMS sur un substrat doté de joints en saillie et de plots électrique. Un deuxième substrat également doté de joints en saillie et de plots électriques complémentaires est rapporté sur le premier substrat en alignant les joints et plots, procurant par la même des zones de vide et des interconnexions électriques entre les deux substrats.

On connaît aussi, du document US 2001/038148, une structure de connexions électriques pour relier un premier substrat à des zones conductrices pourvues sur la surface d'un second substrat disposé sur le premier substrat.

Pour résoudre la plupart des difficultés décrites ci-dessus, l'invention propose, selon un premier aspect, un procédé de fabrication de puce tel que défini dans la revendication.

Ces composants actifs peuvent par exemple être des transistors.

On dira que des composants passifs sont « critiques» lorsque leur élaboration directement sur le substrat contenant les circuits actifs et les interconnexions métalliques poserait problème; pour les raisons expliquées ci-dessus, il peut s'agir par exemple de MEMS, et/ou d'inductances de haute qualité, et/ou de condensateurs dont le matériau diélectrique est une pérovskite.

Certains de ces composants passifs critiques, tels que les MEMS et/ou les condensateurs, sont de préférence élaborés dans ledit second substrat avant ledit scellement des deux substrats.

Grâce à l'invention, on peut notamment élaborer sur une tranche de silicium un second matériau à une température supérieure à la température maximum à laquelle peut être portée la tranche de silicium du fait d'un premier matériau déjà présent sur la tranche. L'invention permet cela en élaborant le second matériau séparément de la tranche de silicium sur laquelle il est destiné à se trouver, puis en intégrant le second matériau sur cette tranche par les techniques de report de couche. Dans le cas particulier des condensateurs de découplage, l'invention permet de porter le matériau diélectrique du condensateur à des températures permettant la cristallisation dans la phase pérovskite, sans aucune restriction imposée par le métal d'interconnexion sous-jacent, et sans avoir recours à une barrière de protection thermique entre les deux matériaux.

Le procédé selon l'invention permet également de réaliser commodément une structure protégeant les MEMS. En effet, les MEMS étant élaborés à la surface du second substrat qui est destiné à être reporté sur le premier substrat, c'est ce premier substrat lui-même (dans lequel on a préalablement aménagé un évidement adéquat) qui sert, après scellement des deux substrats, de structure de protection pour les MEMS. On peut ainsi avantageusement faire l'économie de la réalisation d'un capot selon l'art antérieur.

Selon des caractéristiques particulières de l'invention, on élabore en outre, au cours de la réalisation du second substrat, des tranchées d'isolation diélectrique destinées à réduire les interférences électromagnétiques entre les divers composants de la future puce.

Selon d'autres caractéristiques particulières, on élabore en outre, au cours de la réalisation du second substrat, des composants passifs non critiques tels que des condensateurs en tranchées.

Certains autres composants passifs critiques sont de préférence élaborés après ledit scellement des deux substrats, au voisinage de la face du second substrat opposée à la face de scellement. Dans le cas des inductances, cela permet avantageusement de réduire considérablement les effets des courants induits (pertes d'énergie, perturbations subies par les composants actifs, et ainsi de suite), même lorsque le second substrat est conducteur, puisqu'on place ainsi ces inductances loin du premier substrat.

Afin de diminuer encore plus les pertes par courants induits, et d'améliorer les facteurs de qualité des inductances, celles-ci seront, selon des caractéristiques particulières, élaborées au-dessus de tranchées d'isolation inductive préalablement aménagées dans le second substrat.

Selon un second aspect, l'invention concerne également diverses puces contenant des circuits intégrés.

Elle concerne ainsi, premièrement, une puce qui a été fabriquée au moyen de l'un quelconque des procédés décrits succinctement ci-dessus.

Deuxièmement, une puce non revendiquée contient un circuit intégré comprenant des composants actifs et des composants passifs, et constituée d'un seul empilement de couches, ladite puce étant remarquable en ce qu'elle comporte une interface entre deux desdites couches telle que la partie de la puce située d'un côté de ladite interface contienne au moins un composant actif parmi lesdits composants actifs, et l'autre partie de la puce contienne les composants « critiques» parmi lesdits composants passifs.

Selon des caractéristiques particulières, lesdits composants passifs critiques comprennent des condensateurs dont le matériau diélectrique est une pérovskite, et/ou des MEMS enfermés dans des évidements situés à l'intérieur de ladite puce.

Selon des caractéristiques particulières, la puce comprend en outre des tranchées d'isolation diélectrique.

Selon d'autres caractéristiques particulières, ledit circuit intégré comprend en outre des composants passifs non critiques tels que des condensateurs en tranchées.

Selon d'autres caractéristiques particulières, lesdits composants actifs sont disposés au voisinage d'une première face de la puce, et ledit circuit intégré comprend en outre des inductances situées au voisinage de la face de la puce opposée à ladite première face.

Selon des caractéristiques encore plus particulières, lesdites inductances sont situées au-dessus de tranchées d'isolation inductive.

Selon d'autres caractéristiques particulières, lesdits composants actifs sont disposés au voisinage d'une première face de la puce, et celle-ci comprend en outre des lignes d'interconnexion traversantes qui émergent au voisinage de la face de la puce opposée à ladite première face.

Les avantages offerts par ces puces sont essentiellement les mêmes que ceux offerts par les procédés de fabrication correspondants.

D'autres aspects et avantages de l'invention apparaîtront à la lecture de la description détaillée, que l'on trouvera ci-dessous, de modes particuliers de réalisation donnés à titre d'exemples non limitatifs. Cette description se réfère aux dessins annexés, dans lesquels :
- la figure 1 représente un premier substrat traité selon un mode de réalisation de l'invention,
- la figure 2 représente un second substrat traité selon ce mode de réalisation de l'invention,
- la figure 3 représente l'ensemble obtenu après report, selon l'invention, dudit second substrat 2 sur ledit premier substrat 1,
- la figure 4 représente la puce obtenue selon ce mode de réalisation de l'invention, et
- la figure 5 est une vue agrandie d'une partie de la figure 4.

Conformément au procédé selon l'invention, on commence par préparer deux substrats 1 et 2, dans un ordre quelconque, ou simultanément.

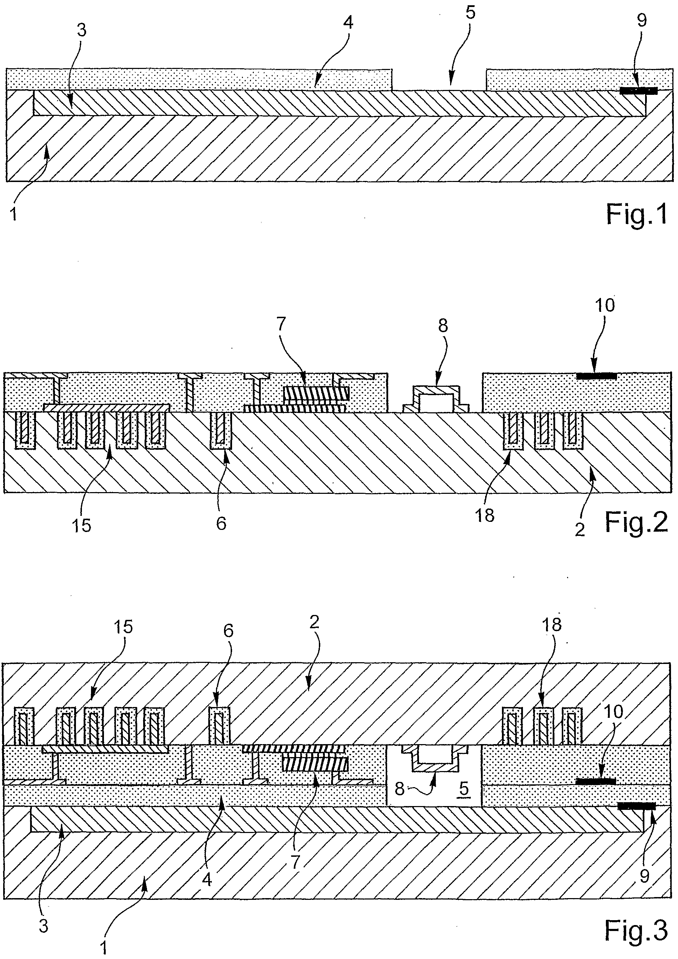

La **figure 1** représente un « premier » substrat 1 constitué par une tranche de silicium ou d'un matériau semi-conducteur quelconque de type III-V. Ce premier substrat 1 contient d'une part des composants actifs 3 qui ont été intégrés selon une technique connue quelconque (par exemple CMOS ou BICMOS), et d'autre part des interconnexions métalliques (non représentées).

Dans ce mode de réalisation, on dépose une couche épaisse 4 d'isolant, par exemple de SiO₂, que l'on grave localement (évidements 5), le cas échéant, à l'aplomb des composants MEMS éventuellement prévus sur le deuxième substrat.

Enfin, on prévoira des plots de métallisation 9, qui seront ultérieurement reliés à d'autres parties de la puce comme expliqué plus bas.

La **figure 2** représente une tranche formant un « second » substrat 2. Dans ce mode de réalisation, ce substrat 2 a été muni :
- de tranchées d'isolation diélectrique 6,
- de condensateurs à très haute constante diélectrique 7,
- de MEMS 8,
- de condensateurs en tranchées 15, et
- de tranchées d'isolation inductive 18.

On va décrire en détail la fabrication de condensateurs 7 dont le matériau diélectrique est une pérovskite. On envisagera à titre d'exemples deux modes de réalisation.

Selon un premier mode de réalisation de condensateurs 7 dont le matériau diélectrique est une pérovskite, on prend un second substrat 2 en un matériau isolant, ou en silicium de haute résistivité, ou en un semi-isolant tel que le verre. On met alors en oeuvre les étapes suivantes :
a) on dépose une couche d'oxyde de silicium SiO₂ ;
b) on dépose une première électrode, qui peut être composée de plusieurs couches de matériaux métalliques, par exemple une couche de Ti ou de RuO₂ ou de IrO₂, recouverte d'une couche de platine ;
c) on dépose, selon une méthode connue quelconque (par exemple « Sol Gel », pulvérisation cathodique, ou « MOCVD »), le matériau diélectrique constitué par une couche mince de pérovskite telle que SrTiO₃, Pb(ZrₓTi₁₋ₓ)O₃ (appelée « PZT ») ou (BaₓSr₁₋ₓ)TiO₃ (appelée « BST ») ;
d) on recuit à haute température (par exemple 700°C) ce diélectrique pour obtenir la phase pérovskite ;
e) on dépose une seconde électrode, qui peut être composée de plusieurs couches de matériaux métalliques, par exemple une couche de platine recouverte d'une couche de Ti ; et
f) de préférence, on dépose une couche d'isolant, par exemple de SiO₂, pour favoriser le collage ultérieur (voir ci-dessous).

Selon un autre procédé de fabrication des condensateurs 7 dont le matériau diélectrique est une pérovskite, on peut utiliser, en guise de second substrat 2, une couche épaisse de pérovskite obtenue au préalable. Dans ce cas, on omettra les étapes a) à d) décrites ci-dessus.

Le procédé selon l'invention permet ainsi de réaliser, à la température élevée requise, des condensateurs possédant un diélectrique de très haute constante diélectrique, sans craindre pour autant d'endommager les composants actifs ou les interconnexions métalliques du futur circuit intégré.

Les composants MEMS 8, qui peuvent être à fonctionnement électromécanique ou électroacoustique, tels que des micro-commutateurs électromécaniques ou des résonateurs acoustiques, sont réalisés de manière connue par une succession de dépôts et de gravures.

On va à présent décrire en détail la fabrication de condensateurs en tranchées 15. Il s'agit de condensateurs de large surface d'électrodes, et donc, eux aussi, de forte capacité, qui sont implantés conformément à l'article de F. Roozeboom cité ci-dessus. Plus précisément :
a) on réalise la gravure de tranchées selon des motifs prédéfinis et sur une profondeur légèrement supérieure à l'épaisseur du futur substrat après amincissement (voir ci-dessous) ;
b) on fait croître sur les faces de chaque tranchée un diélectrique de haute qualité ; l'épaisseur de ce diélectrique doit être aussi faible que possible de façon à ce que la capacité des condensateurs 15 soit aussi grande que possible ; par exemple, si l'on prévoit que la tension qui sera appliquée aux bornes des condensateurs sera de quelques volt, on fera croître une épaisseur de diélectrique comprise, de préférence, entre 10 et 50 nm ; dans le cas où le substrat 2 est en silicium, on utilisera avantageusement pour cela l'oxyde de silicium obtenu par effet thermique, en association éventuellement avec une nitruration ou un dépôt de nitrure de silicium ; on peut aussi utiliser, par exemple, des diélectriques de plus haute permittivité comme Al₂O₃, HgO2, ou Ta₂O₅ déposés de manière connue ;
c) on remplit les tranchées d'un matériau fortement conducteur pour réaliser une des armatures du condensateur; on peut par exemple utiliser pour ce faire du silicium polycristallin non dopé (ou dopé *in situ*) ; et
d) on réalise une gravure localisée par masquage dudit matériau fortement conducteur pour délimiter des zones en surface du substrat 2 et isoler les armatures du condensateur du reste du circuit semi-conducteur.

On choisira de préférence, pour constituer le substrat 2, un matériau de haute conductivité (tel que le silicium) car le substrat constituera une des armatures des condensateurs en tranchées. Les flancs des tranchées du côté du substrat devront être fortement dopés pour rendre le substrat suffisamment conducteur. Enfin, on réalisera un contact ohmique sur le substrat afin de pouvoir relier une électrode des condensateurs à un circuit électrique.

En variante, dans le cas des circuits intégrés ne comportant pas de condensateurs en tranchées, il est préférable au contraire de choisir, pour constituer le deuxième substrat 2, un matériau de faible conductivité (tel que le verre) pour limiter les pertes dues aux courants induits engendrés par les inductances (voir ci-dessous).

En offrant la possibilité de creuser des tranchées profondes dans le second substrat 2, l'invention permet de développer une grande surface d'électrodes pour ces condensateurs, et d'augmenter ainsi considérablement, pour une surface latérale donnée de substrat, la valeur de la capacité par rapport à un procédé d'intégration monolithique classique.

Quant aux tranchées d'isolation inductive 18, elles sont réalisées conformément à l'enseignement du brevet US-6,310,387 résumé ci-dessus. Comme on l'a expliqué, ces tranchées 18 contribuent à la réalisation d'inductances de haute qualité.

Enfin, on réalise des métallisations permettant de confectionner des contacts sur les armatures des condensateurs de très forte capacité 7 et sur les MEMS 8, et de les relier entre eux. On prévoira également des plots de métallisation 10 qui seront ensuite reliés à d'autres parties de la puce par des passages aménagés à travers le second substrat 2 (voir plus bas).

De préférence, on appliquera ici un polissage mécano-chimique à la couche supérieure de la tranche ainsi obtenue, afin de lui conférer une rugosité favorisant le report de couche par adhésion moléculaire.

La **figure 3** représente l'ensemble obtenu après collage, selon l'invention, du second substrat 2 sur le premier substrat 1.

Le scellement entre le premier substrat 1 le second substrat 2 pourra être réalisé, de préférence, par adhésion moléculaire ou par collage polymère ; de préférence, on évitera d'utiliser une colle en couche afin de ne pas augmenter le nombre total de couches. Mais on pourra aussi réaliser ce scellement, par exemple, par soudure eutectique ou anodique (en anglais, « *anodic bonding* ») ; on notera toutefois que les soudures et les brasures peuvent être ici d'un usage peu commode, en raison de problèmes, bien connus de l'homme du métier, de mouillabilité, de dégazage, ou d'isolation thermique associés à ces techniques.

On voit ainsi que dans la puce résultant du procédé selon l'invention, l'interface au niveau de laquelle les deux substrats ont été scellés délimite deux parties de la puce, une partie contenant au moins un composant actif du circuit intégré, et l'autre partie contenant les composants critiques du circuit intégré.

On notera en particulier, dans ce mode de réalisation, le respect de l'alignement entre les MEMS 8 et les évidements 5. Le procédé de fabrication selon l'invention assure ainsi la protection des composants électromécaniques tels que ces MEMS 8.

A ce stade, pour compléter la fabrication de la puce selon l'invention, il est nécessaire de construire le réseau d'interconnexions permettant de connecter les électrodes des condensateurs, et le réseau d'interconnexions sous-jacent du second substrat 2. On notera que, dans le cadre de l'invention, il s'agit ici d'accéder à des couches enterrées, contrairement aux procédés de fabrication monolithiques selon l'état de l'art dans lesquels on peut déposer et graver immédiatement chaque couche successive.

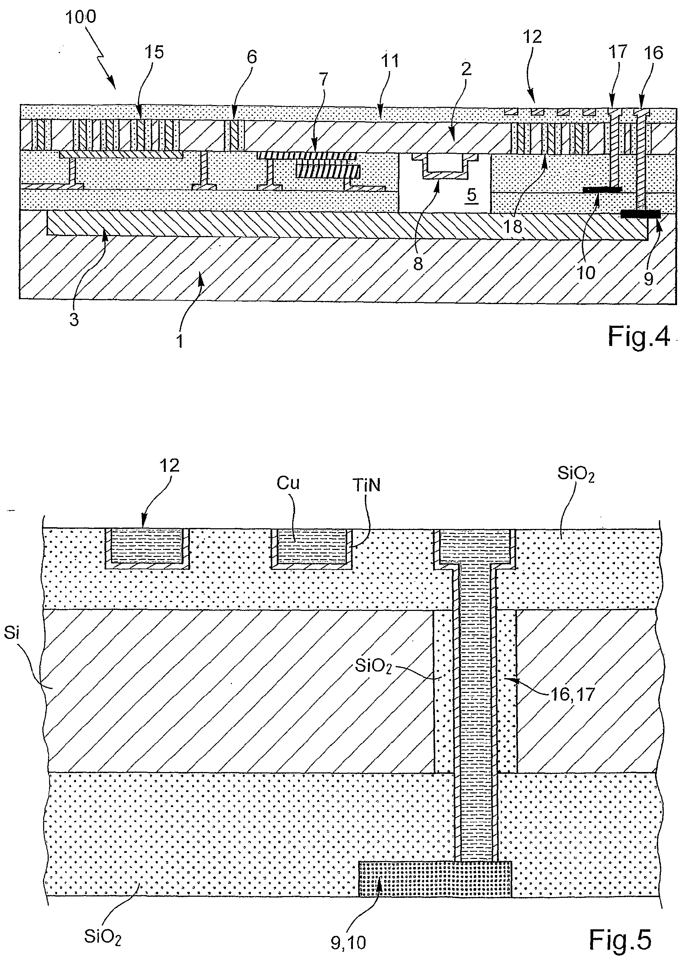

Ces étapes finales vont conduire à la puce 100 illustrée sur la **figure 4****.**
a) On amincit et polit le second substrat 2 ; pour ce faire, on peut par exemple appliquer un polissage mécano-chimique ; on peut aussi, comme expliqué dans le brevet EP0807970, réaliser une implantation ionique dans un plan du substrat 2, de façon à créer des microcavités qui fragilisent le substrat et permettent une fracture subséquente suivant ce plan. On poursuit l'amincissement jusqu'à pénétrer dans les structures en tranchées 6, 15, et 18.
b) On grave localement le second substrat 2 puis les couches diélectriques à l'aplomb de façon à dégager les futurs contacts sur les plots de métallisation 9 et sur les plots de métallisation 10.
c) On dépose un isolant 11, en SiO₂ par exemple, à basse température, de façon à recouvrir la surface libre du second substrat 2.
d) On réalise des électrodes traversantes 16 (resp. 17) pour connecter les plots de métallisation 9 (resp. 10) à la surface libre de l'isolant 11. Dans ce mode de réalisation, on utilise à cet effet la technique divulguée dans l'article de M. Tomisaka et al. intitulé « Electroplating Cu Fillings for Through-Vias for Three-Dimensional Chip Stacking » (Electronic Components and Technology Conference, 2002). Cette interconnexion entre les composants du premier substrat 1 et les composants du second substrat 2 au moyen d'électrodes traversantes est illustrée sur la **figure 5**. On grave d'abord l'isolant 11 de façon à :
   - réaliser, à des endroits prédéterminés destinés à délimiter de futures lignes conductrices, des motifs en creux ainsi que des trous (en anglais, « *vias* ») dans cet isolant, et
   - éliminer l'isolant au fond des vias.
   Puis on réalise une métallisation conductrice sur la surface, et dans les trous qui ont été réalisés dans l'isolant. Pour cela, on dépose de fines couches de TaN ou TiN, et on utilise ce fond continu pour réaliser une électrolyse de cuivre épais.
e) On aplanit ce cuivre et ledit fond continu selon des techniques connues (par exemple, par polissage mécano-chimique) jusqu'à leur élimination complète des zones hautes de l'isolant, pour ne laisser du métal que dans les motifs en creux dessinés à l'étape d), dans les tranchées de l'isolant et dans les trous verticaux : on obtient ainsi, d'une part, des électrodes traversantes (16,17), et d'autre part, en surface, des inductances 12 selon une structure dite « Damascene » (voir la figure 5). L'épaisseur des creux et du métal seront choisis de façon à minimiser la résistance de cette couche.

Selon un autre mode de réalisation, la métallisation peut être réalisée, de manière connue, par une partie traversante en tungstène associée à des lignes ou des plots en aluminium.

L'invention permet de diminuer fortement les pertes par courants induits puisque, en réalisant ces inductances 12 sur la face du second substrat 2 opposée à la face de scellement, on éloigne ces inductances 12 du premier substrat 1 (qui peut être un bon conducteur), d'une épaisseur pouvant être élevée, et que les tranchées 18 situées sous les inductances 12 suppriment les courants induits.

La présente invention ne se limite pas aux modes de réalisation décrits ci-dessus : en fait, l'homme de l'art pourra mettre en oeuvre diverses variantes de l'invention tout en restant à l'intérieur de la portée des revendications ci-jointes. Par exemple, on a décrit ci-dessus des modes de réalisation dans lesquels la gravure des diverses couches était effectuée après report du second substrat sur le premier ; mais il est parfaitement possible d'effectuer certaines étapes de gravure sur le premier substrat 1 et/ou sur le second substrat 2 avant l'étape de report. D'autre part, on pourra naturellement ajouter d'autres éléments, tels que des couches barrière ou des couches anti-adhésives, aux éléments composant les modes de réalisation décrits ci-dessus.

Quel que soit le mode de réalisation choisi, le procédé de fabrication selon l'invention comprend, comme expliqué ci-dessus et comme illustré sur les figures, le scellement des substrats (1) et (2) par report de couche, c'est-à-dire par adhésion d'une face du premier substrat (1) à une face du second substrat (2) sur la majeure partie de leur surface (adhésion « pleine tranche »).

On notera que la puce ainsi obtenue est particulièrement robuste, car constituée d'un seul empilement de couches (par rapport aux dispositifs selon l'art antérieur constitués de parties reliées entre elles par des joints, ou des perlures, de soudure ou de brasure). Cette robustesse permet notamment de réaliser en toute sécurité des évidements (motifs en creux, vias, et ainsi de suite) dans la puce au cours des derniers stades de sa fabrication, c'est-à-dire *après* le scellement des deux substrats ; comme expliqué ci-dessus, on peut ainsi mettre en place de manière particulièrement commode des inductances ou des interconnexions (par exemple) dans le circuit intégré. On notera également que la puce ainsi obtenue est, pour les mêmes raisons, particulièrement compacte par rapport auxdits dispositifs selon l'art antérieur.

## Revendications

1. Procédé de fabrication de puce contenant un circuit intégré comprenant des composants actifs et des composants passifs, le procédé comprenant les étapes suivantes :
- on réalise un premier substrat (1) contenant au moins un composant actif (3) parmi lesdits composants actifs et présentant une première couche, et
- on réalise un second substrat (2) contenant des composants critiques (7,8) parmi lesdits composants passifs et présentant une seconde couche, en portant ledit second substrat, pour fabriquer les composants critiques, à une température supérieure à une température maximale à partir de laquelle le premier substrat subit des dégradations inacceptables, et
le procédé étant **caractérisé en ce qu'**il comprend les étapes suivantes:
- on scelle les deux substrats (1) et (2) par report de couche par adhésion moléculaire entre la première et la seconde couche, et
- on élabore, après ledit scellement des deux substrats (1) et (2), au moins une ligne d'interconnexion (16,17) entre les composants desdites deux substrats (1) et (2), ladite ligne d'interconnexion traversant ledit second substrat (2).

2. Procédé selon la revendication 1, **caractérisé en ce que** ledit au moins un composant actif (3) comprend des transistors.

3. Procédé selon la revendication 1 ou la revendication 2, **caractérisé en ce que** lesdits composants passifs critiques comprennent au moins un condensateur (7) et/ou au moins un MEMS (8).

4. Procédé selon la revendication 3, **caractérisé en ce que** le matériau diélectrique dudit au moins un condensateur (7) est une pérovskite.

5. Procédé selon l'une quelconque des revendications 1 à 4, **caractérisé en ce que** ledit second substrat (2) est en un matériau électriquement conducteur.

6. Procédé selon l'une quelconque des revendications 1 à 4, **caractérisé en ce que** ledit second substrat (2) est en un matériau diélectrique.

7. Procédé selon la revendication 6, **caractérisé en ce que** le second substrat (2) est en pérovskite.

8. Procédé selon l'une quelconque des revendications précédentes, **caractérisé en ce que** l'on élabore en outre, au cours de la réalisation du second substrat (2), des tranchées d'isolation diélectrique (6).

9. Procédé selon l'une quelconque des revendications précédentes, **caractérisé en ce que** l'on élabore en outre, au cours de la réalisation du second substrat (2), au moins un composant passif non critique tel qu'un condensateur en tranchées (15).

10. Procédé selon l'une quelconque des revendications précédentes, **caractérisé en ce que** l'on élabore en outre, après ledit scellement des deux substrats (1) et (2), au moins une inductance (12) au voisinage de la face du second substrat (2) opposée à la face de scellement.

11. Procédé selon la revendication 10, **caractérisé en ce que** l'on élabore ladite au moins une inductance (12) au-dessus de tranchées d'isolation inductive (18) préalablement aménagées dans le second substrat (2).

12. Procédé selon la revendication 10, **caractérisé en ce que** lesdites au moins une inductance (12) et au moins une ligne d'interconnexion (16, 17) sont élaborées dans un même métal en une même étape.

## Patentansprüche

1. Verfahren zur Herstellung eines Chips, der eine integrierte Schaltung enthält, die aktive Bestandteile und passive Bestandteile umfasst, wobei das Verfahren die folgenden Schritte umfasst, dass:
- ein erstes Substrat (1), das zumindest einen aktiven Bestandteil (3) unter den aktiven Bestandteilen enthält und eine erste Schicht aufweist, realisiert wird, und
- ein zweites Substrat (2), das kritische Bestandteile (7, 8) unter den passiven Bestandteilen enthält und eine zweite Schicht aufweist, realisiert wird, wobei das zweite Substrat zur Herstellung der kritischen Bestandteile auf eine Temperatur gebracht wird, die höher als eine maximale Temperatur ist, ausgehend von der das erste Substrat unannehmbare Schädigungen erfährt, und
wobei das Verfahren **dadurch gekennzeichnet ist, dass** es die folgenden Schritte umfasst, dass:
- die beiden Substrate (1) und (2) durch Schichtübertragung durch molekulare Anhaftung zwischen der ersten und der zweiten Schicht versiegelt werden, und
- nach der Versiegelung der beiden Substrate (1) und (2) zumindest eine Verbindungsleitung (16, 17) zwischen den Bestandteilen der beiden Substrate (1) und (2) ausgearbeitet wird, wobei die Verbindungsleitung durch das zweite Substrat (2) verläuft.

2. Verfahren nach Anspruch 1, **dadurch gekennzeichnet, dass** der zumindest eine aktive Bestandteil (3) Transistoren umfasst.

3. Verfahren nach Anspruch 1 oder Anspruch 2, **dadurch gekennzeichnet, dass** die kritischen passiven Bestandteile zumindest einen Kondensator (7) und/oder zumindest ein MEMS (8) umfassen.

4. Verfahren nach Anspruch 3, **dadurch gekennzeichnet, dass** das dielektrische Material des zumindest einen Kondensators (7) ein Perovskit ist.

5. Verfahren nach einem der Ansprüche 1 bis 4, **dadurch gekennzeichnet, dass** das zweite Substrat (2) aus einem elektrischen leitenden Material besteht.

6. Verfahren nach einem der Ansprüche 1 bis 4, **dadurch gekennzeichnet, dass** das zweite Substrat (2) aus einem dielektrischen Material besteht.

7. Verfahren nach Anspruch 6, **dadurch gekennzeichnet, dass** das zweite Substrat (2) aus Perovskit besteht.

8. Verfahren nach einem der vorhergehenden Ansprüche, **dadurch gekennzeichnet, dass** außerdem im Verlaufe der Realisierung des zweiten Substrats (2) dielektrische Isolationsgräben (6) ausgearbeitet werden.

9. Verfahren nach einem der vorhergehenden Ansprüche, **dadurch gekennzeichnet, dass** außerdem im Verlaufe der Realisierung des zweiten Substrats (2) zumindest ein nichtkritischer passiver Bestandteil, wie etwa ein als Graben ausgebildeter Kondensator (15), ausgearbeitet wird.

10. Verfahren nach einem der vorhergehenden Ansprüche, **dadurch gekennzeichnet, dass** nach dem Versiegeln der zwei Substrate (1) und (2) zumindest eine Induktivität (12) in der Nachbarschaft der der Versiegelungsfläche entgegengesetzten Fläche des zweiten Substrats (2) ausgearbeitet wird.

11. Verfahren nach Anspruch 10, **dadurch gekennzeichnet, dass** die zumindest eine Induktivität (12) über induktive Isolationsgräben ausgearbeitet wird, die zuvor in dem zweiten Substrat (2) vorgesehen wurden.

12. Verfahren nach Anspruch 10, **dadurch gekennzeichnet, dass** die zumindest eine Induktivität (12) und zumindest eine Verbindungsleitung (16, 17) in dem gleichen Metall in einem gleichen Schritt ausgearbeitet werden.

## Claims

1. A method of fabricating a chip containing an integrated circuit comprising active components and passive components, the method comprising the following steps:
- producing a first substrate (1) containing at least one active component (3) among said active components and having a first layer, and
- producing a second substrate (2) containing critical passive components (7, 8) among said passive components and having a second layer, and bearing said second substrate, to fabricate the critical components, at a temperature higher than a maximum temperature above which the first substrate undergoes unacceptable degradation, and
- sealing the two substrates (1) and (2) by layer transfer by molecular adhesion between the first and second layer, and
- after said sealing of the two substrates (1) and (2), producing at least one interconnection line (16, 17) between the components of said two substrates (1) and (2), said interconnection line passing through the second substrate.

2. A method according to claim 1, **characterised in that** said at least one active component (3) comprises transistors.

3. A method according to claim 1 or claim 2, **characterised in that** said critical passive components comprise at least one capacitor (7) and/or at least one MEMS (8).

4. A method according to claim 3, **characterised in that** the dielectric material of said at least one capacitor (7) comprises a perovskite.

5. A method according to any one of claims 1 to 4, **characterised in that** said second substrate (2) is of an electrically conductive material.

6. A method according to any one of claims 1 to 4, **characterised in that** said second substrate (2) is of a dielectric material.

7. A method according to claim 6, **characterised in that** the second substrate (2) is of perovskite.

8. A method according to any one of the preceding claims, **characterized in that** dielectric insulation trenches (6) are furthermore produced during the production of the second substrate.

9. A method according to any one of the preceding claims, **characterized in that** at least one non-critical passive component such as a capacitor (15) in trenches is furthermore produced during the production of the second substrate (2).

10. A method according to any one of the preceding claims, **characterized in that**, after said sealing of the two substrates (1) and (2), at least one inductor (12) is produced in the vicinity of the opposite face of the second substrate (2) to the sealing face.

11. A method according to claim 10 **characterized in that** at least one inductor (12) is produced over the inductive insulation trenches (18) formed beforehand in the second substrate (2).

12. A method according to claim 10, **characterised in that** said at least one inductor (12) and at least one interconnection line (16, 17) are produced from a same metal and in a same step.
